# EUROPEAN PATENT APPLICATION

(11) **EP 4 709 128 A1**
(43) Date of publication of application: **11.03.2026**
(21) Application number: 25197431.7
(22) Date of filing: 21.08.2025
(51) Int. Cl.: H10N 69/00

(54) **QUANTUM BIT DEVICE AND METHOD FOR MANUFACTURING QUANTUM BIT DEVICE**

(30) Priority: 29.08.2024 JP 2024147954
(71) Applicant: Fujitsu Limited, Kawasaki-shi, Kanagawa 211-8588 (JP)
(72) Inventor: SHIMANOUCHI, Takeaki, 211-8588 Kawasaki-shi (JP); TABUCHI, Yutaka, 351-0198 Wako-shi, Saitama, (JP)
(74) Representative: Haseltine Lake Kempner LLP

(57) **Abstract**

A quantum bit device (100) includes: a first quantum bit substrate (10) including a first quantum bit (1A), a second quantum bit (1B), and a ground electrode extending between the first quantum bit and the second quantum bit; and a connection substrate (20) including a first coupled line (22) that forms capacitive coupling between the first quantum bit and the second quantum bit.

## Description

### FIELD

The disclosed technology relates to a quantum bit device and a method for manufacturing the quantum bit device.

### BACKGROUND

As a technology related to a quantum bit device, the following technology is known. Patent Literature 1 describes a quantum processor in which a plurality of qubits formed on a surface of a substrate are arranged in a pattern. The nearest qubits in the pattern are connected, and the quantum processor includes a long range connector configured to connect a first qubit of the plurality of qubits to a second qubit of the plurality of qubits. The first and second qubits are separated by at least a third qubit in the pattern.

Patent Literature 2 describes a quantum computing device including a first chip having a plurality of qubits disposed on a first substrate and a second chip having at least one conductive surface disposed on a second substrate opposite the plurality of qubits.

### Related Patent Documents

Patent Literature 1: Japanese National-Phase Publication (JP-A) No. 2023-505418
Patent Literature 2: Japanese National-Phase Publication (JP-A) No. 2022-528739

As a quantum bit constituting a quantum bit device, a quantum bit using a transmon is known. The transmon has a configuration in which a superconducting Josephson element and a capacitor are connected in parallel, and performs a quantum operation using nonlinear energy. In a multi-bit quantum bit device, a plurality of quantum bits are connected to each other via a capacitor.

The quantum bit device may include a base material such as a silicon substrate, a plurality of quantum bits provided on a first surface of the base material, and a control port provided immediately below each quantum bit on a second surface of the base material and to which a control signal for controlling a state of the quantum bits is input. The quantum bit substrate is provided with a coupled line for forming capacitive coupling between the quantum bits.

In the quantum bit device having the above configuration, when a state of a certain quantum bit is controlled, a control signal is input to a control port provided immediately below the quantum bit. The control signal input to the control port may propagate inside the base material and be transmitted to another adjacent quantum bit via the coupled line. That is, according to the quantum bit device having the above configuration, the control signal may leak to the coupled line and there is a possibility that crosstalk occurs, in which the control signal is transmitted to an unintended quantum bit.

### SUMMARY

The disclosed technology has been made in view of the above points, and an object thereof is to suppress leakage of a control signal to a coupled line in a quantum bit device having the coupled line for forming capacitive coupling between quantum bits.

A quantum bit device according to the disclosed technology includes: a first quantum bit substrate having a first quantum bit, a second quantum bit, and a ground electrode extending between the first quantum bit and the second quantum bit; and a connection substrate having a first coupled line that forms capacitive coupling between the first quantum bit and the second quantum bit.

### BRIEF DESCRIPTION OF THE DRAWINGS

Fig. 1 is a diagram schematically illustrating an example of a configuration of a quantum bit device according to an embodiment of the disclosed technology;
Fig. 2 is a plan view illustrating an example of a layout on a first surface of a quantum bit substrate according to an embodiment of the disclosed technology;
Fig. 3 is a plan view illustrating an example of a layout on a second surface of a quantum bit substrate according to an embodiment of the disclosed technology;
Fig. 4 is a cross-sectional view taken along a line 4-4 in Fig. 1;
Fig. 5 is an equivalent circuit diagram of an operation block according to an embodiment of the disclosed technology;
Fig. 6A is a plan view illustrating an example of a configuration of a capacitor according to an embodiment of the disclosed technology;
Fig. 6B is a cross-sectional view illustrating an example of the configuration of the capacitor according to an embodiment of the disclosed technology;
Fig. 7A is a cross-sectional view illustrating an example of a process of manufacturing the quantum bit substrate according to an embodiment of the disclosed technology;
Fig. 7B is a cross-sectional view illustrating an example of the process of manufacturing the quantum bit substrate according to the embodiment of the disclosed technology;
Fig. 7C is a cross-sectional view illustrating an example of the process of manufacturing the quantum bit substrate according to the embodiment of the disclosed technology;
Fig. 7D is a cross-sectional view illustrating an example of the process of manufacturing the quantum bit substrate according to the embodiment of the disclosed technology;
Fig. 7E is a cross-sectional view illustrating an example of the process of manufacturing the quantum bit substrate according to the embodiment of the disclosed technology;
Fig. 7F is a cross-sectional view illustrating an example of the process of manufacturing the quantum bit substrate according to the embodiment of the disclosed technology;
Fig. 7G is a cross-sectional view illustrating an example of the process of manufacturing the quantum bit substrate according to the embodiment of the disclosed technology;
Fig. 7H is a cross-sectional view illustrating an example of the process of manufacturing the quantum bit substrate according to the embodiment of the disclosed technology;
Fig. 8A is a cross-sectional view illustrating an example of a manufacturing process of a connection substrate according to an embodiment of the disclosed technology;
Fig. 8B is a cross-sectional view illustrating an example of the manufacturing process of the connection substrate according to the embodiment of the disclosed technology;
Fig. 8C is a cross-sectional view illustrating an example of the manufacturing process of the connection substrate according to the embodiment of the disclosed technology;
Fig. 8D is a cross-sectional view illustrating an example of the manufacturing process of the connection substrate according to the embodiment of the disclosed technology;
Fig. 8E is a cross-sectional view illustrating an example of the manufacturing process of the connection substrate according to the embodiment of the disclosed technology;
Fig. 9A is a view illustrating an example of a process of combining a quantum bit substrate and a connection substrate;
Fig. 9B is a view illustrating an example of a process of combining the quantum bit substrate and the connection substrate;
Fig. 10 is a diagram schematically illustrating an example of a configuration of a quantum bit device according to a comparative example;
Fig. 11 is a cross-sectional view taken along a line 11-11 in Fig. 10;
Fig. 12 is a cross-sectional view of a quantum bit device according to an embodiment of the disclosed technology;
Fig. 13 is a diagram schematically illustrating an example of a configuration of a quantum bit device according to another embodiment of the disclosed technology;
Fig. 14 is a plan view illustrating an example of a layout on one surface of a connection substrate according to another embodiment of the disclosed technology;
Fig. 15 is a plan view illustrating an example of a layout on the other surface of a connection substrate according to another embodiment of the disclosed technology;
Fig. 16 is a cross-sectional view taken along a line 16-16 in Fig. 13;
Fig. 17 illustrates a cross section taken along a line 17-17 in Fig. 13;
Fig. 18 is a diagram schematically illustrating an example of a configuration of a quantum bit device according to another embodiment of the disclosed technology;
Fig. 19 is a cross-sectional view taken along a line 19-19 in Fig. 18;
Fig. 20 is a diagram schematically illustrating an example of a configuration of a quantum bit device according to another embodiment of the disclosed technology; and
Fig. 21 is a cross-sectional view taken along a line 21-21 in Fig. 20.

### DESCRIPTION OF EMBODIMENTS

Hereinafter, an example of an embodiment of the disclosed technology will be described with reference to the drawings. In the drawings, the same or equivalent components and portions are denoted by the same reference numerals, and redundant description is omitted.

### First Embodiment

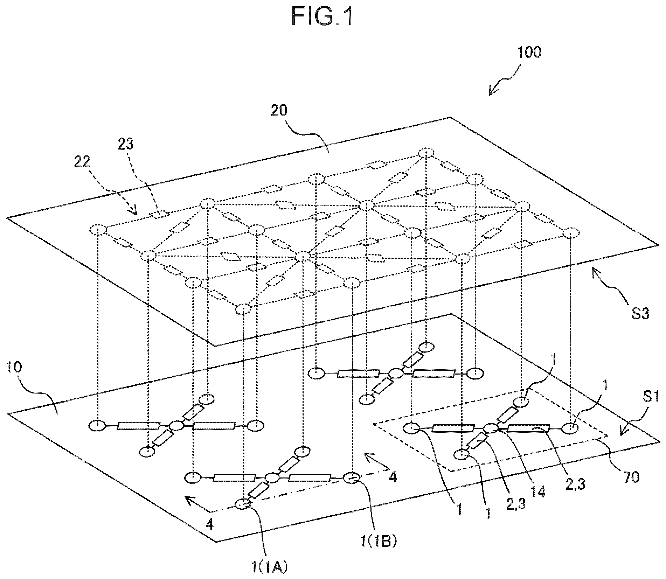

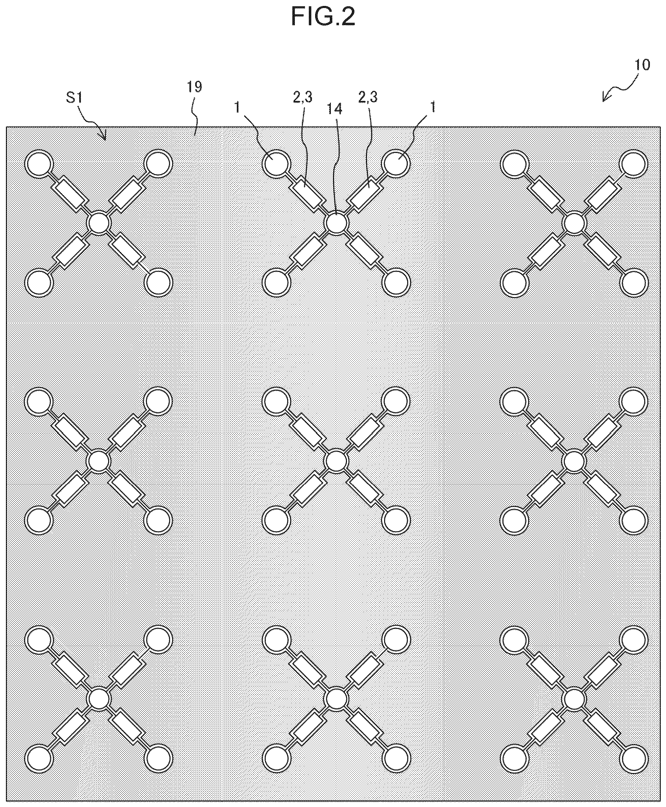

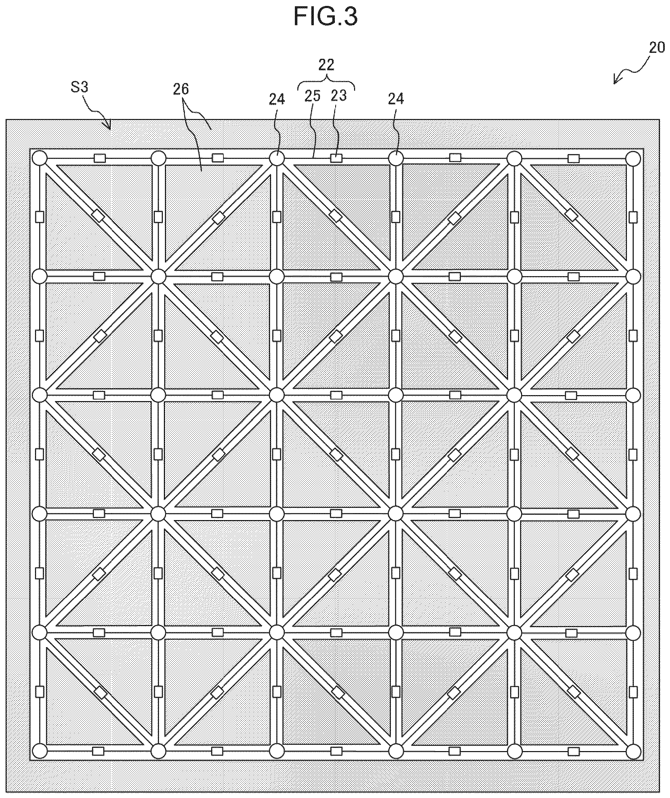

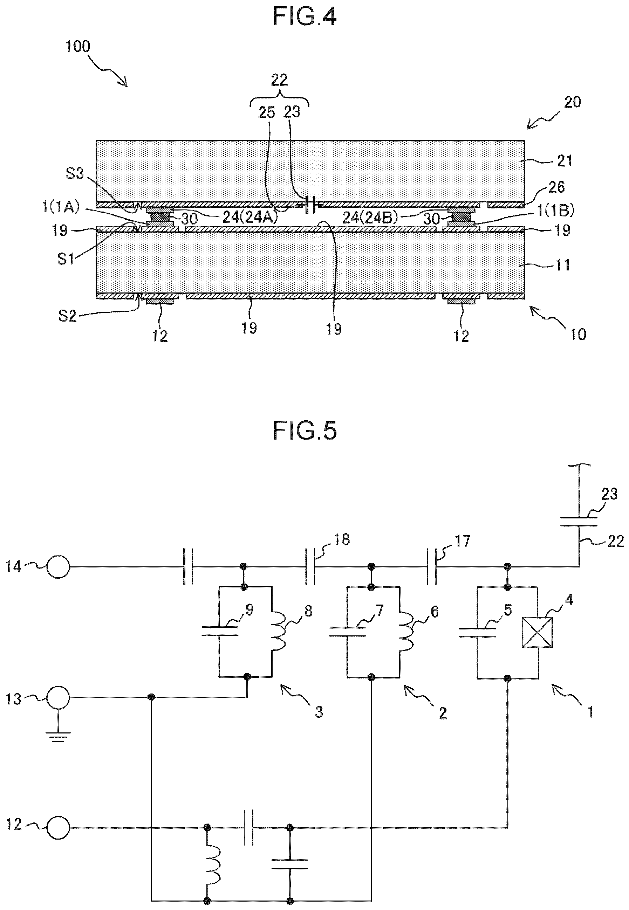

Fig. 1 is a diagram schematically illustrating an example of a configuration of a quantum bit device 100 according to an embodiment of the disclosed technology. The quantum bit device 100 includes a quantum bit substrate 10 and a connection substrate 20. These substrates are stacked such that a surface S1 of the quantum bit substrate 10 and a surface S3 of the connection substrate 20 face each other. Fig. 2 is a plan view illustrating an example of a layout on the surface S1 of the quantum bit substrate 10, and Fig. 3 is a plan view illustrating an example of a layout on the surface S3 of the connection substrate 20 facing the surface S1 of the quantum bit substrate 10. Fig. 4 is a cross-sectional view of the quantum bit device 100, illustrating a cross section taken along a line 4-4 in Fig. 1.

The quantum bit device 100 has four quantum bits 1 provided on the quantum bit substrate 10 as a basic unit 70. Four quantum bits 1 constituting one basic unit 70 are arranged at positions corresponding to four vertexes of a square, and a reading port 14 is arranged at the center of the square. One reading port 14 is shared by four quantum bits 1. A resonator 2 and a filter 3 are provided on each path from each of the four quantum bits 1 to the reading port 14. Each quantum bit 1 is connected to another adjacent quantum bit 1 via a coupled line 22 including a capacitor 23 provided on the connection substrate 20. As a result, capacitive coupling is formed between the quantum bits adjacent to each other. Each quantum bit 1 creates a quantum entangled state with another adjacent quantum bit 1 and performs a quantum operation.

Fig. 5 is an equivalent circuit diagram of an operation block including one quantum bit 1, one resonator 2, and one filter 3. The quantum bit 1 is an element that forms a coherent two-level system using superconductivity and performs a quantum operation using nonlinear energy. The quantum bit 1 has a transmon in which a Josephson element 4 and the capacitor 5 are connected in parallel. The Josephson element 4 includes a pair of superconductor layers that exhibits superconductivity at a temperature equal to or lower than a predetermined critical temperature, and an ultrathin insulator layer having a thickness of about several nm sandwiched between the pair of superconductor layers. The superconductor layer may be, for example, aluminum, and the insulator layer may be, for example, aluminum oxide.

The resonator 2 is connected to the quantum bit 1 via a capacitor 17. The resonator 2 interacts with the quantum bit 1 to read out a response signal indicating the state of the quantum bit 1. The resonator 2 has a resonance circuit in which a superconducting inductor 6 and a capacitor 7 are connected in parallel. The filter 3 is connected to the resonator 2 via a capacitor 18. The filter 3 suppresses relaxation of the signal having the frequency of the quantum bit 1 to the reading port 14. Similarly to the resonator 2, the filter 3 has a resonance circuit in which a superconducting inductor 8 and a capacitor 9 are connected in parallel.

A control port 12, a ground port 13, and the reading port 14 are connected to the operation block. A control signal for controlling the quantum bit 1 is input to the control port 12. The state of the quantum bit 1 is controlled by the control signal input to the control port 12. The response signal indicating the state of the quantum bit 1 is read from the reading port 14. The ground port 13 is connected to an external ground potential. The ground potential of the ground port 13 is shared by the ground of each portion of the operation block.

The quantum bit substrate 10 has a base material 11 made of, for example, silicon. A quantum bit 1, a resonator 2, and a filter 3 are provided on a surface S1 of the base material 11. The reading port 14 has a through-electrode structure penetrating the base material 11. The response signal output via the resonator 2 and the filter 3 is transmitted to a surface S2 of the base material 11 on the side opposite to the surface 1 by the reading port 14 of the through-electrode structure.

On the surface S1 of the base material 11, the ground electrode 19 is provided so as to cover almost the entire region except for the formation region of the quantum bit 1, the resonator 2, the filter 3, and the reading port 14. That is, the ground electrode 19 extends between two quantum bits 1 adjacent to each other. A ground potential is externally supplied to the ground electrode 19 through the ground port 13. A control port 12 is provided immediately below each quantum bit 1 on the surface S2 of the base material 11. A control signal input to the control port 12 acts on the quantum bit 1 via the base material 11. The ground electrode 19 is also provided on the surface S2 of the base material 11.

The connection substrate 20 has a base material 21 made of, for example, silicon. A plurality of coupling pads 24 are provided on a surface S3 of the base material 21 facing the quantum bit substrate 10. The plurality of coupling pads 24 are arranged so as to correspond to the plurality of respective quantum bits 1 provided on the quantum bit substrate 10. That is, the plurality of coupling pads 24 are provided in a lattice array corresponding to the array of the plurality of quantum bits 1 provided on the quantum bit substrate 10. Each of the plurality of coupling pads 24 is connected to the corresponding quantum bit 1 via a bump 30.

The coupled line 22 is provided on the surface S3 of the connection substrate 20. The coupled line 22 includes a wiring 25 and a capacitor 23 provided in the middle of the wiring 25. The coupling pads 24 are connected to both ends of each of the plurality of coupled lines 22. All of the coupling pads 24 are connected to any other adjacent coupling pad 24 via the coupled line 22. In the present embodiment, not only the coupling pads adjacent to each other in the lattice direction but also the coupling pads adjacent to each other in the diagonal direction are connected to each other via the coupled line 22 (see Fig. 3). On the surface S3 of the connection substrate 20, a ground electrode 26 is provided so as to cover substantially the entire region except for the formation region of the coupled line 22 and the coupling pad 24.

One end of the coupled line 22 is connected to the quantum bit 1A via the coupling pad 24A, and the other end of the coupled line 22 is connected to the quantum bit 1B adjacent to the quantum bit 1A via the coupling pad 24B (see Fig. 4). As a result, capacitive coupling is formed between the quantum bits adjacent to each other. All the quantum bits 1 provided on the quantum bit substrate 10 are connected to any other adjacent quantum bits 1 via the coupled line 22 provided on the connection substrate 20. In the present embodiment, not only between the quantum bits adjacent to each other in the lattice direction but also between the quantum bits adjacent to each other in the diagonal direction are connected to each other via the coupled line 22 (see Fig. 1). The ground electrode 19 provided on the quantum bit substrate 10 is disposed at a position overlapping the coupled line 22 in plan view.

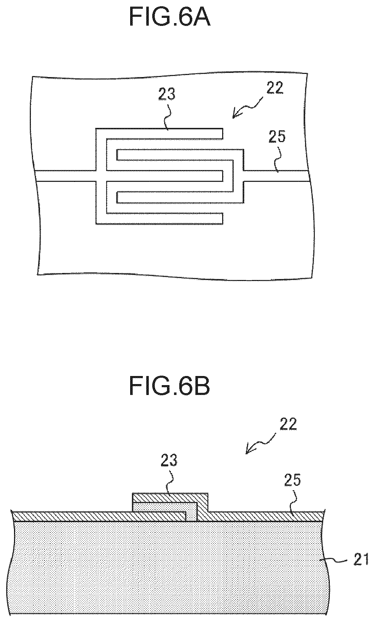

The capacitor 23 is provided in the middle of the wiring 25 constituting the coupled line 22. For example, as illustrated in Fig. 6A, the capacitor 23 may be a planar capacitor including, as an electrode, a pair of comb-shaped conductors formed on a surface of base material 21 of connection substrate 20. Furthermore, as illustrated in Fig. 6B, the capacitor 23 may be a laminated capacitor having a metal/insulator/metal (MIM) structure formed on the surface of the base material 21.

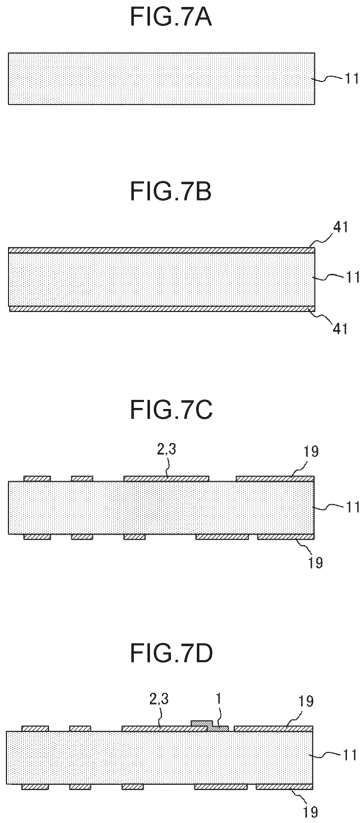

Hereinafter, a method of manufacturing the quantum bit device 100 will be described. Figs. 7A to 7H are cross-sectional views illustrating an example of a process of manufacturing the quantum bit substrate 10.

First, the base material 11 of the quantum bit substrate 10 is prepared. As the base material 11, for example, a silicon substrate having a thickness of about 300 µm can be used (Fig. 7A). Next, a conductive film 41 having a thickness of about 100 nm is formed on both surfaces of the base material 11 using, for example, a sputtering method, plasma chemical vapor deposition (CVD), or an ion plating method. For example, TiN can be used as the material of the conductive film 41 (Fig. 7B). Next, a resist mask (not illustrated) is formed on the surface of the conductive film 41, and the conductive film 41 is patterned by partially etching the conductive film 41 through the resist mask. As a result, the resonator 2, the filter 3, the ground electrode 19, and the like are formed (Fig. 7C).

Next, a quantum bit 1 is formed on the surface of the base material 11 (Fig. 7D). The superconducting Josephson element constituting the quantum bit 1 is formed through, for example, a step of forming a lower electrode (not illustrated) containing Al on the surface of the base material 11 by a vapor deposition method, a step of forming an extremely thin oxide film (not illustrated) having a thickness of about several nm on the surface of the lower electrode using an O₂ gas, and a step of forming an upper electrode (not illustrated) containing Al on the surface of the oxide film by a vapor deposition method. The lower electrode and the upper electrode may be patterned by, for example, a lift-off method using a patterned resist mask (not illustrated). In this case, the opening pattern of the resist mask may have a cross shape having a first linear portion along a first direction and a second linear portion along a second direction orthogonal to the first direction, and the lower electrode may be formed in a portion corresponding to the first linear portion by performing vapor deposition while inclining the resist mask about the first direction as a rotation axis. Subsequently, the upper electrode may be formed in a portion corresponding to the second linear portion by performing vapor deposition while inclining the resist mask about the second direction as the rotation axis. According to the above method, the lower electrode and the upper electrode can be patterned by a single resist mask.

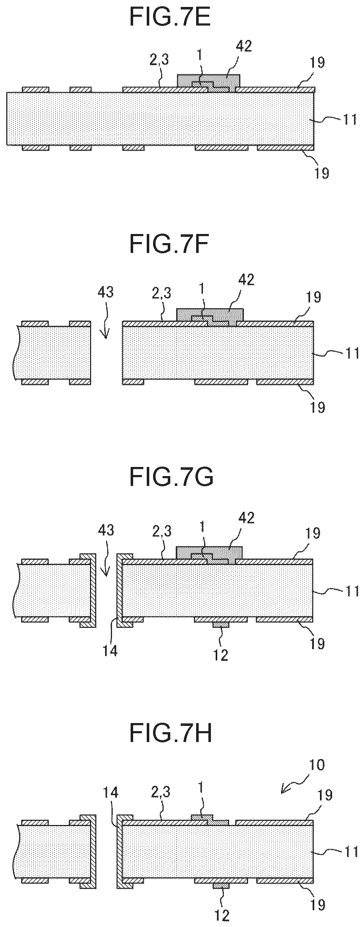

Next, a protective film 42 covering the surface of the quantum bit 1 is formed by, for example, a CVD method. For example, SiO₂ can be used as the material of the protective film 42. Thereafter, the protective film 42 is patterned using a photolithography technique (Fig. 7E). Next, a hard mask (not illustrated) having an opening at the formation position of the reading port 14 is formed, and a through hole 43 is formed at the formation position of the reading port 14 of the base material 11 by, for example, a deep-reactive ion etching (RIE) method using the hard mask (Fig. 7F). Next, a conductive film that covers the inner wall of the through hole 43 and the periphery of the opening end of the through hole 43 is formed by, for example, a vapor deposition method. For example, Al can be used as the material of the conductive film. Thereafter, the conductive film is patterned by, for example, a lift-off method. As a result, the control port 12 and the reading port 14 are formed (Fig. 7G). Next, the protective film 42 covering the quantum bit 1 is removed by etching using, for example, vapor hydrofluoric acid (Fig. 7H). Through the above steps, the quantum bit substrate 10 is completed.

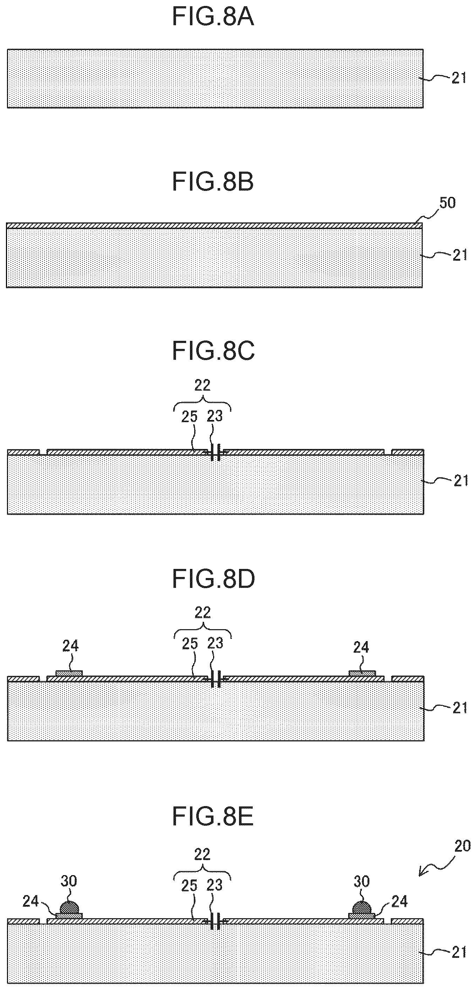

Figs. 8A to 8E are cross-sectional views illustrating an example of a manufacturing process of the connection substrate 20. First, the base material 21 of the connection substrate 20 is prepared. As the base material 21, for example, a silicon substrate having a thickness of about 300 µm can be used (Fig. 8A).

Next, a conductive film 50 having a thickness of about 100 nm is formed on the surface of the base material 21 using, for example, a sputtering method, plasma CVD, or an ion plating method. For example, TiN can be used as the material of the conductive film 50 (Fig. 8B). Next, a resist mask (not illustrated) is formed on the surface of the conductive film 50, and the conductive film 50 is patterned by partially etching the conductive film 50 through the resist mask. As a result, the coupled line 22 including the wiring 25 and the capacitor 23 is formed (Fig. 8C).

Next, a patterned resist mask (not illustrated) is formed on the surface of the coupled line 22. Next, a conductive film such as an Al film is formed on the surface of the coupled line 22 through a resist mask by a vapor deposition method. Next, the conductive film on the resist mask is removed together with the resist mask to pattern the conductive film. As a result, the coupling pads 24 connected to one end and the other end of the coupled line 22 are formed (Fig. 8D). Next, the bump 30 is formed on the surface of the coupling pad 24. For example, In can be used as the material of the bump 30 (Fig. 8E). Through the above steps, the connection substrate 20 is completed.

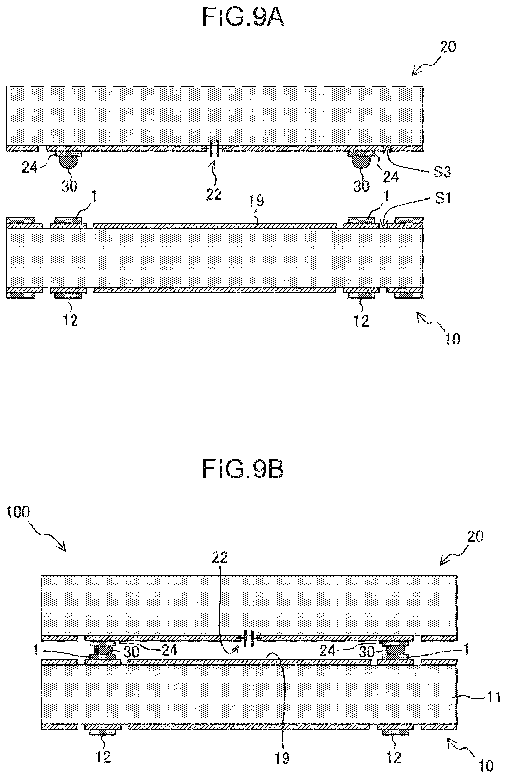

Figs. 9A and 9B are diagrams illustrating an example of a process of combining the quantum bit substrate 10 and the connection substrate 20. These substrates are arranged such that the surface S1 of the quantum bit substrate 10 on which the quantum bit 1 is formed faces the surface S3 of the connection substrate 20 on which the coupled line 22 and the coupling pad 24 are formed (Fig. 9A). Next, each of the plurality of coupling pads 24 provided on the connection substrate 20 and the corresponding quantum bit 1 provided on the quantum bit substrate 10 are connected via the bump 30 (Fig. 9B). As a result, the quantum bit substrate 10 and the connection substrate 20 are bonded, and capacitive coupling is formed between the quantum bits adjacent to each other.

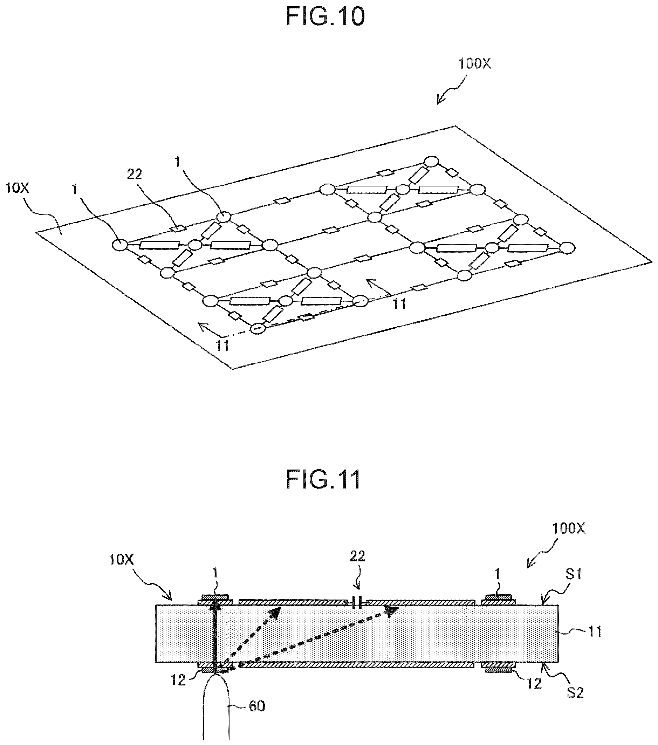

Fig. 10 is a diagram schematically illustrating an example of a configuration of a quantum bit device 100X according to a comparative example. Fig. 11 is a cross-sectional view taken along a line 11-11 in Fig. 10. The quantum bit device 100X according to the comparative example does not include the connection substrate 20 included in the quantum bit device 100 according to the embodiment of the disclosed technology. In the quantum bit device 100X according to the comparative example, the coupled line 22 is provided on the surface S1 of the quantum bit substrate 10X, and the control port 12 is provided immediately below each quantum bit 1 on the surface S2 of the base material 11. In the case of controlling the state of the quantum bit 1, a control signal is input via a probe 60 brought into contact with a control port 12 provided immediately below the target quantum bit 1. The control signal acts on the target quantum bit 1 via the base material 11. According to the quantum bit device 100X according to the comparative example, the control signal input to the control port 12 may propagate inside the base material 11 and leak to the coupled line 22, and there is a possibility that crosstalk occurs in which the control signal is transmitted to the unintended quantum bit 1.

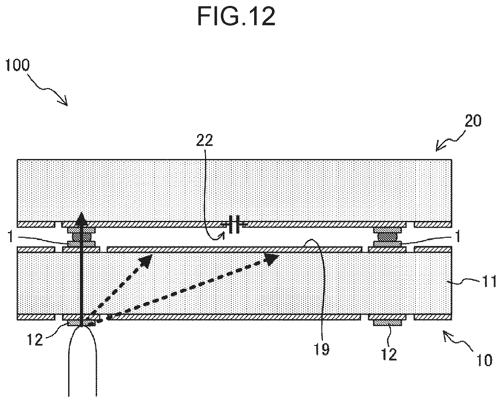

On the other hand, according to the quantum bit device 100 according to the embodiment of the disclosed technology, the coupled line 22 is provided on the connection substrate 20 different from the quantum bit substrate 10, and the ground electrode 19 is disposed at a position overlapping the coupled line 22 in plan view. That is, the ground electrode 19 is disposed on a propagation path of the control signal from the control port 12 to the coupled line 22 (see Fig. 12). As a result, the control signal propagating inside the base material 11 is blocked by the ground electrode 19, and leakage of the control signal to the coupled line 22 can be suppressed.

Furthermore, according to the quantum bit device 100 according to the embodiment of the disclosed technology, the coupled line 22 is provided on the connection substrate 20 different from the quantum bit substrate 10. This makes it possible to form capacitive coupling not only between the quantum bits adjacent to each other in the lattice direction but also between the quantum bits adjacent to each other in the diagonal direction. As a result, the number of other quantum bits connected to one quantum bit increases as compared with the quantum bit device 100X according to the comparative example. As a result, since the number of formable two-qubit gates is increased, the quantum operation processing capability of the quantum bit device can be increased.

### Second Embodiment

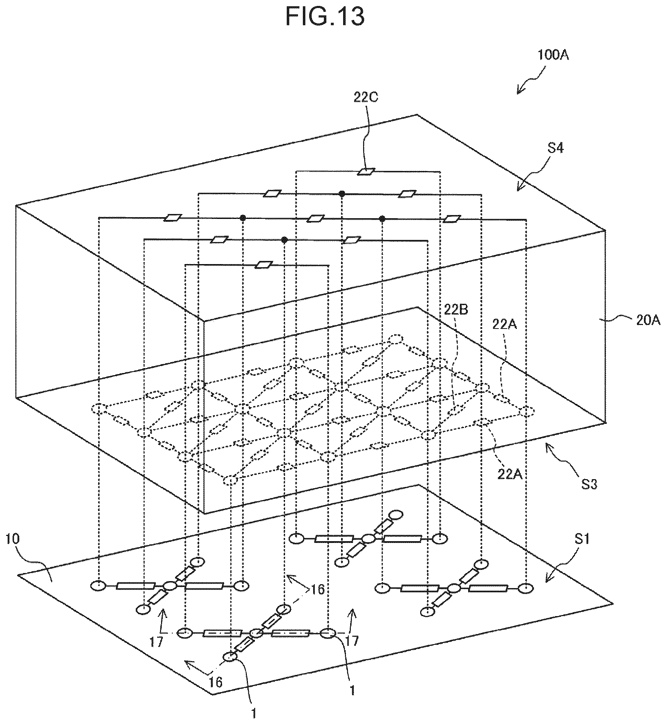

Fig. 13 is a diagram schematically illustrating an example of a configuration of a quantum bit device 100A according to a second embodiment of the disclosed technology. The quantum bit device 100A includes a quantum bit substrate 10 and a connection substrate 20A. These substrates are stacked such that a surface S1 of the quantum bit substrate 10 and a surface S3 of the connection substrate 20 face each other. The quantum bit device 100A according to the second embodiment is different from the connection substrate 20 according to the first embodiment described above in the configuration of the connection substrate 20A. The connection substrate 20A has coupled lines on both surfaces.

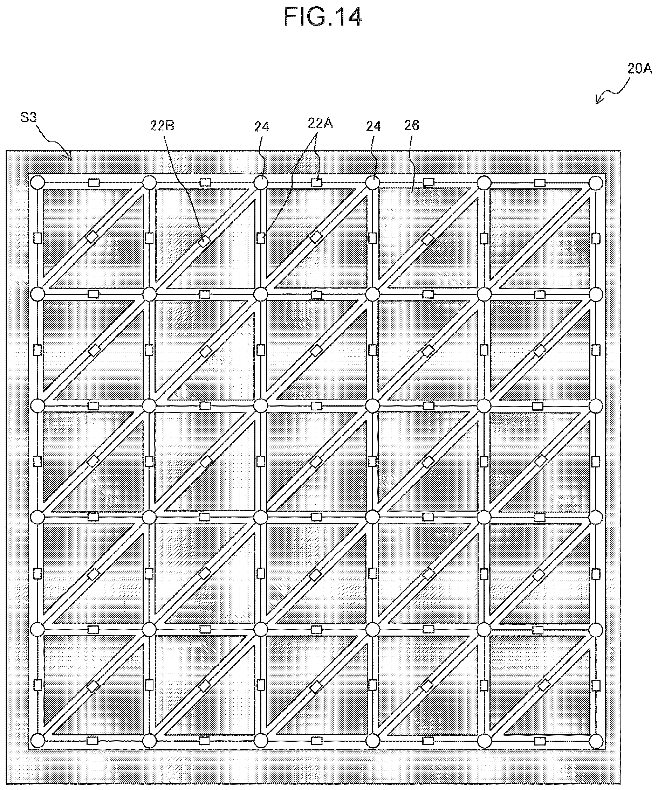

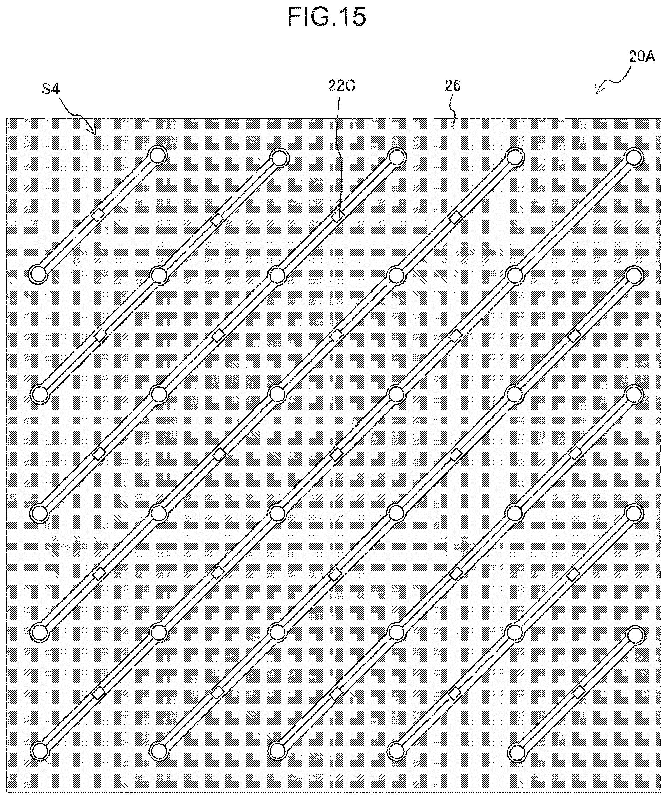

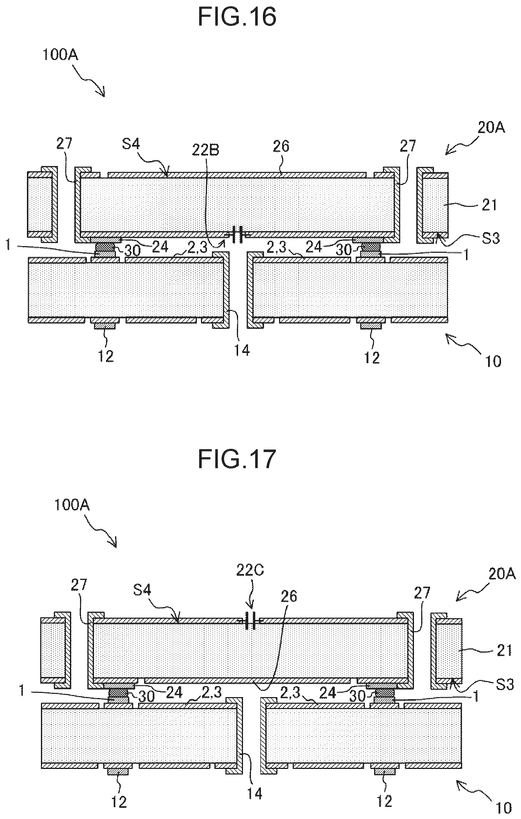

Fig. 14 is a plan view illustrating an example of a layout on the surface S3 of the connection substrate 20A facing the surface S1 of the quantum bit substrate 10. Fig. 15 is a plan view illustrating an example of a layout on a surface S4 opposite to the surface S3 of the connection substrate 20A. Fig. 16 is a cross-sectional view of the quantum bit device 100A, and illustrates a cross section taken along a line 16-16 in Fig. 13. Fig. 17 is a cross-sectional view of the quantum bit device 100A, and illustrates a cross section taken along a line 17-17 in Fig. 13.

On the surface S3 of the connection substrate 20A, a coupled line 22A connecting the quantum bits adjacent to each other in the lattice direction and a coupled line 22B connecting the quantum bits adjacent to each other in the diagonal direction are provided. The surface S4 is provided with a coupled line 22C that connects quantum bits adjacent to each other in the diagonal direction. The coupled line 22B provided on the surface S3 and the coupled line 22C provided on the surface S4 are arranged in directions intersecting each other. Note that the coupled lines 22A and 22B are an example of the "first coupled line" in the disclosed technology. The coupled line 22C is an example of the "second coupled line" in the disclosed technology.

As illustrated in Fig. 17, the coupled line 22C provided on the surface S4 of the connection substrate 20A is connected to the coupling pad 24 provided on the surface S3 of the connection substrate 20A via the through-electrode 37 penetrating the base material 21 of the connection substrate 20A. The coupling pad 24 is connected to the quantum bit 1 provided on the quantum bit substrate 10 via the bump 30. On the surface S3 and the surface S4 of the connection substrate 20, a ground electrode 26 is provided so as to cover almost all regions except for the formation regions of the coupled lines 22A, 22B, and 22C, the coupling pad 24, and the through-electrode 27.

According to the quantum bit device 100A according to the second embodiment of the disclosed technology, similarly to the quantum bit device 100 according to the first embodiment described above, it is possible to suppress leakage of the control signal to the coupled line 22. Furthermore, the capacitive coupling between the quantum bits that is not formed by the coupled lines 22A and 23B provided on the surface S3 of the connection substrate 20Ais formed by the coupled line 22C provided on the surface S4 of the connection substrate 20A. As a result, the number of other quantum bits connected to one quantum bit 1 is further increased as compared with the quantum bit device 100 according to the first embodiment. As a result, since the number of formable two-qubit gates is further increased, the quantum operation processing capability of the quantum bit device can be further increased.

### Third Embodiment

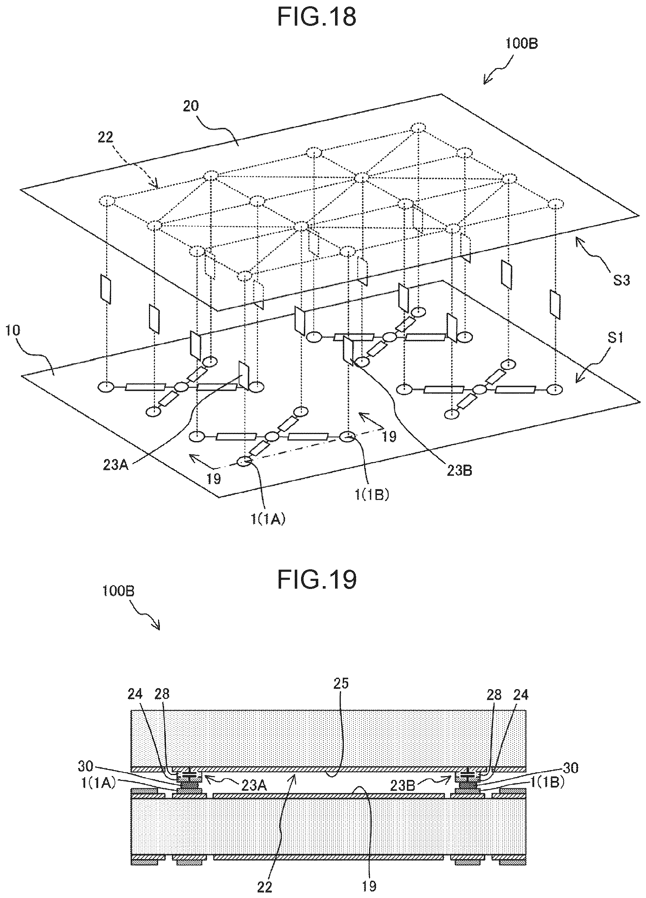

Fig. 18 is a diagram schematically illustrating an example of a configuration of a quantum bit device 100B according to a third embodiment of the disclosed technology. Fig. 19 is a cross-sectional view of the quantum bit device 100B, illustrating a cross section taken along a line 19-19 in Fig. 18.

In the quantum bit devices according to the first and second embodiments described above, the capacitor 23 for forming capacitive coupling between quantum bits is provided in the middle of the wiring 25 constituting the coupled line 22. In the quantum bit device 100B according to the third embodiment, a capacitor for forming capacitive coupling between quantum bits is provided at a bonding portion between the quantum bit 1 and the coupled line 22. That is, the coupled line 22 includes a wiring 25, a capacitor 23A provided between one end of the wiring 25 and the quantum bit 1A, and a capacitor 23B provided between the other end of the wiring 25 and the quantum bit 1B. Each of the capacitors 23A and 23B has an end of the wiring 25 as one electrode, has a coupling pad 24 as the other electrode, and has a dielectric 28 such as Al₂O₃ sandwiched between these electrodes. The coupling pads 24 are connected to the quantum bits 1A and 1B via the bumps 30, respectively. The capacitor 23A is an example of the "first capacitor" in the disclosed technology. The capacitor 23B is an example of the "second capacitor" in the disclosed technology. The quantum bit 1A and the quantum bit 1B are connected to each other via the coupled line 22 including the capacitor 23A, the wiring 25, and the capacitor 23B. As a result, capacitive coupling is formed between the quantum bit 1A and the quantum bit 1B.

According to the quantum bit device 100B according to the third embodiment of the disclosed technology, similarly to the quantum bit device 100 according to the first embodiment described above, it is possible to suppress leakage of the control signal to the coupled line 22.

### Fourth Embodiment

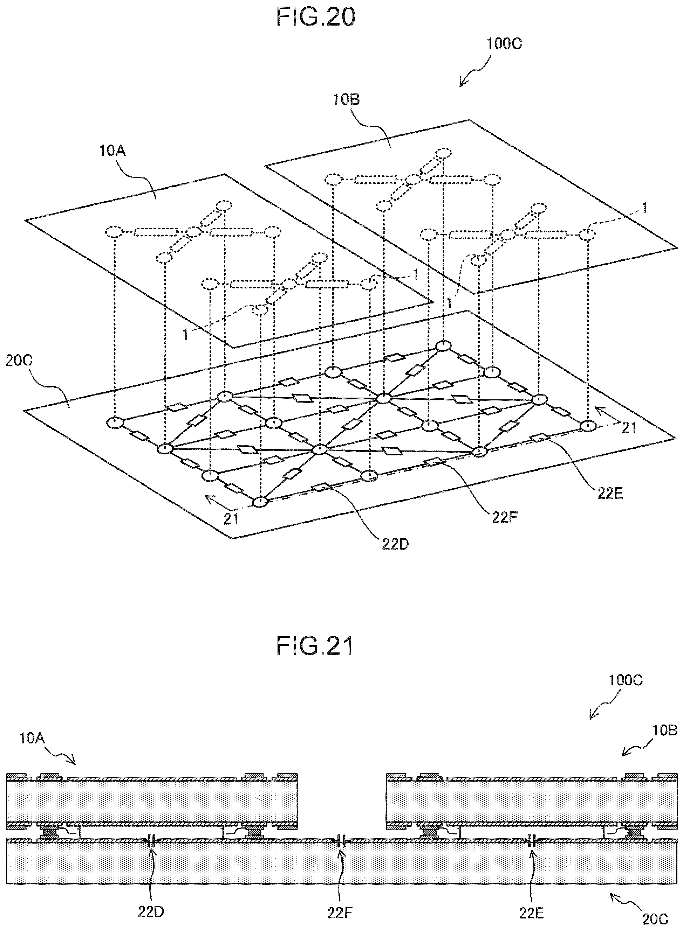

Fig. 20 is a diagram schematically illustrating an example of a configuration of a quantum bit device 100C according to a fourth embodiment of the disclosed technology. Fig. 21 is a cross-sectional view of the quantum bit device 100C, and illustrates a cross section taken along a line 21-21 in Fig. 20.

The quantum bit device 100C includes quantum bit substrates 10A and 10B each having a plurality of quantum bits 1. The quantum bit substrates 10A and 10B are mounted on the connection substrate 20C. The connection substrate 20C includes a coupled line 22D that forms capacitive coupling between quantum bits provided on the quantum bit substrate 10A and a coupled line 22E that forms capacitive coupling between quantum bits provided on the quantum bit substrate 10B. The connection substrate 20C further includes a coupled line 22F that forms capacitive coupling between the quantum bit 1 provided on the quantum bit substrate 10A and the quantum bit 1 provided on the quantum bit substrate 10B. The quantum bit substrate 10A is an example of the "first quantum bit substrate" in the disclosed technology. The quantum bit substrate 10B is an example of the "second quantum bit substrate" in the disclosed technology.

According to the quantum bit device 100C according to the fourth embodiment of the disclosed technology, similarly to the quantum bit device 100 according to the first embodiment described above, it is possible to suppress leakage of the control signal to the coupled line 22. In addition, since a plurality of quantum bit substrates are provided, the number of bits can be increased as compared with a case where only a single quantum bit substrate is provided. In addition, since capacitive coupling is also formed between the quantum bits provided on the quantum bit substrates different from each other, each quantum bit 1 can be handled without being conscious of the boundary between the quantum bit substrates.

According to the disclosed technology, in a quantum bit device having a coupled line for forming capacitive coupling between quantum bits, leakage of a control signal to the coupled line can be suppressed.

With regard to the first to fourth embodiments described above, the following supplementary notes are further disclosed.

### (Supplement 1)

A quantum bit device including:
a first quantum bit substrate including a first quantum bit, a second quantum bit, and a ground electrode extending between the first quantum bit and the second quantum bit; and
a connection substrate including a first coupled line that forms capacitive coupling between the first quantum bit and the second quantum bit.

### (Supplement 2)

The quantum bit device according to Supplement 1, in which
the first quantum bit substrate and the connection substrate are disposed so as to overlap each other, and
the ground electrode is disposed at a position overlapping the first coupled line in plan view.

### (Supplement 3)

The quantum bit device according to Supplement 1 or 2, in which
the first quantum bit substrate includes a control port to which a control signal for controlling the first quantum bit is input, and
the ground electrode is disposed on a propagation path of the control signal from the control port to the first coupled line.

### (Supplement 4)

The quantum bit device according to Supplement 3, in which
the first quantum bit and the second quantum bit are provided on one surface of the first quantum bit substrate, and
the control port is provided on the other surface of the first quantum bit substrate.

### (Supplement 5)

The quantum bit device according to any one of Supplement 1 to 4, in which one end of the first coupled line is connected to the first quantum bit via a first pad, and the other end of the first coupled line is connected to the second quantum bit via a second pad.

### (Supplement 6)

The quantum bit device according to any one of Supplement 1 to 5, in which
the first coupled line includes:
a wire; and
a capacitor provided in the middle of the wiring.

### (Supplement 7)

The quantum bit device according to any one of Supplement 1 to 5, in which
the first coupled line includes:
a wire;
a first capacitor provided between one end of the wiring and the first quantum bit; and
a second capacitor provided between the other end of the wiring and the second quantum bit.

### (Supplement 8)

The quantum bit device according to any one of Supplement 1 to 7, in which
the first coupled line is provided on one surface of the connection substrate, and
the connection substrate includes a second coupled line that is provided on the other surface of the connection substrate and forms capacitive coupling between a quantum bit other than the second quantum bit and the first quantum bit.

### (Supplement 9)

The quantum bit device according to any one of Supplement 1 to 8, further including
a second quantum bit substrate including a plurality of quantum bits,
in which the connection substrate includes a coupled line that forms capacitive coupling between a quantum bit provided on the first quantum bit substrate and a quantum bit provided on the second quantum bit substrate.

### (Supplement 10)

A method for manufacturing a quantum bit device, the method including:
forming a first quantum bit substrate including a first quantum bit, a second quantum bit, and a ground electrode extending between the first quantum bit and the second quantum bit;
forming a connection substrate including a first coupled line that forms capacitive coupling between the first quantum bit and the second quantum bit; and
combining the first quantum bit substrate and the connection substrate.

### (Supplement 11)

The method for manufacturing according to Supplement 10, in which
the first quantum bit substrate and the connection substrate are disposed so as to overlap each other, and
the ground electrode is disposed at a position overlapping the first coupled line in plan view.

### (Supplement 12)

The method for manufacturing according to Supplement 10 or 11, in which
the first quantum bit substrate includes a control port to which a control signal for controlling the first quantum bit is input, and
the ground electrode is disposed on a propagation path of the control signal from the control port to the first coupled line.

### (Supplement 13)

The method for manufacturing according to Supplement 12, in which
the first quantum bit and the second quantum bit are provided on one surface of the first quantum bit substrate, and
the control port is provided on the other surface of the first quantum bit substrate.

### (Supplement 14)

The method for manufacturing according to any one of Supplement 10 to 13, in which
the first coupled line is provided on one surface of the connection substrate, and
the connection substrate includes a second coupled line that is provided on the other surface of the connection substrate and forms capacitive coupling between a quantum bit other than the second quantum bit and the first quantum bit.

### (Supplement 15)

The method for manufacturing according to any one of Supplement 10 to 14, further including:
forming a second quantum bit substrate including a plurality of quantum bits; and
combining the second quantum bit substrate and the connection substrate,
in which the connection substrate includes a coupled line that forms capacitive coupling between a quantum bit provided on the first quantum bit substrate and a quantum bit provided on the second quantum bit substrate.

## Claims

1. A quantum bit device including:
a first quantum bit substrate including a first quantum bit, a second quantum bit, and a ground electrode extending between the first quantum bit and the second quantum bit; and
a connection substrate including a first coupled line that forms capacitive coupling between the first quantum bit and the second quantum bit.

2. The quantum bit device according to claim 1, in which
the first quantum bit substrate and the connection substrate are disposed so as to overlap each other, and
the ground electrode is disposed at a position overlapping the first coupled line in plan view.

3. The quantum bit device according to claim 1 or 2, in which
the first quantum bit substrate includes a control port to which a control signal for controlling the first quantum bit is input, and
the ground electrode is disposed on a propagation path of the control signal from the control port to the first coupled line.

4. The quantum bit device according to claim 3, in which
the first quantum bit and the second quantum bit are provided on one surface of the first quantum bit substrate, and
the control port is provided on the other surface of the first quantum bit substrate.

5. The quantum bit device according to any one of claim 1 to 4, in which one end of the first coupled line is connected to the first quantum bit via a first pad, and the other end of the first coupled line is connected to the second quantum bit via a second pad.

6. The quantum bit device according to any one of claim 1 to 5, in which
the first coupled line includes:
a wire; and
a capacitor provided in the middle of the wiring.

7. The quantum bit device according to any one of claim 1 to 5, in which
the first coupled line includes:
a wire;
a first capacitor provided between one end of the wiring and the first quantum bit; and
a second capacitor provided between the other end of the wiring and the second quantum bit.

8. The quantum bit device according to any one of claim 1 to 7, in which
the first coupled line is provided on one surface of the connection substrate, and
the connection substrate includes a second coupled line that is provided on the other surface of the connection substrate and forms capacitive coupling between a quantum bit other than the second quantum bit and the first quantum bit.

9. The quantum bit device according to any one of claim 1 to 8, further including
a second quantum bit substrate including a plurality of quantum bits,
in which the connection substrate includes a coupled line that forms capacitive coupling between a quantum bit provided on the first quantum bit substrate and a quantum bit provided on the second quantum bit substrate.

10. A method for manufacturing a quantum bit device, the method including:
forming a first quantum bit substrate including a first quantum bit, a second quantum bit, and a ground electrode extending between the first quantum bit and the second quantum bit;
forming a connection substrate including a first coupled line that forms capacitive coupling between the first quantum bit and the second quantum bit; and
combining the first quantum bit substrate and the connection substrate.

11. The method for manufacturing according to claim 10, in which
the first quantum bit substrate and the connection substrate are disposed so as to overlap each other, and
the ground electrode is disposed at a position overlapping the first coupled line in plan view.

12. The method for manufacturing according to claim 10 or 11, in which
the first quantum bit substrate includes a control port to which a control signal for controlling the first quantum bit is input, and
the ground electrode is disposed on a propagation path of the control signal from the control port to the first coupled line.

13. The method for manufacturing according to claim 12, in which
the first quantum bit and the second quantum bit are provided on one surface of the first quantum bit substrate, and
the control port is provided on the other surface of the first quantum bit substrate.

14. The method for manufacturing according to any one of claim 10 to 13, in which
the first coupled line is provided on one surface of the connection substrate, and
the connection substrate includes a second coupled line that is provided on the other surface of the connection substrate and forms capacitive coupling between a quantum bit other than the second quantum bit and the first quantum bit.

15. The method for manufacturing according to any one of claim 10 to 14, further including:
forming a second quantum bit substrate including a plurality of quantum bits; and
combining the second quantum bit substrate and the connection substrate,
in which the connection substrate includes a coupled line that forms capacitive coupling between a quantum bit provided on the first quantum bit substrate and a quantum bit provided on the second quantum bit substrate.
